# EUROPEAN PATENT SPECIFICATION

(11) **EP 2 971 275 B1**
(45) Date of publication and mention of the grant of the patent: **21.02.2018**
(21) Application number: 14721103.1
(22) Date of filing: 14.03.2014
(51) Int. Cl.: C30B 15/12, C30B 29/06

(54) **CRUCIBLE ASSEMBLY FOR CONTROLLING OXYGEN AND RELATED METHODS**
TIEGELANORDNUNG ZUR SAUERSTOFFSTEUERUNG UND ZUGEHÖRIGE VERFAHREN
ENSEMBLE CREUSET DESTINÉ À RÉGULER L'OXYGÈNE ET PROCÉDÉS ASSOCIÉS

(30) Priority: 14.03.2013 US 201313804585; 15.03.2013 US 201313837092
(43) Date of publication of application: 20.01.2016
(73) Proprietor: Sunedison, Inc., St. Peters, Missouri 63376 (US)
(72) Inventor: KIMBEL, Steven L., St. Peters, Missouri 63376 (US); FERGUSON, Steve J., St. Peters, Missouri 63376 (US); SWAMINATHAN, Tirumani N., St. Peters, Missouri 63376 (US); ZEPEDA, Salvador, St. Peters, Missouri 63376 (US); HILKER, John David, St. Peters, Missouri 63376 (US); HOLZER, Joseph C., St. Peters, Missouri 63376 (US); MEYER, Benjamin M., St. Peters, Missouri 63376 (US); HOLDER, John D., St. Peters, Missouri 63376 (US)
(74) Representative: Maiwald Patentanwalts GmbH
(86) International application number: PCT/US2014/027981
(87) International publication number: WO 2014/152852

(56) References cited:
- EP-A1- 0 530 825
- WO-A1-91/17289
- JP-A- H 046 198
- US-A- 5 284 631
- US-B1- 8 262 797
- SHIMAMURA K ET AL: "A new crystal growth method for in situ core doping", JOURNAL OF CRYSTAL GROWTH, ELSEVIER, AMSTERDAM, NL, vol. 142, no. 3-4, 2 September 1994 (1994-09-02), pages 400-402, XP026975056, ISSN: 0022-0248 [retrieved on 1994-09-02]

## Description

### FIELD

This disclosure generally relates to systems and methods for the production of ingots of semiconductor or solar material and more particularly to systems and methods for reducing defects or dislocations in the ingots.

### BACKGROUND

In the production of single silicon crystals grown by the Czochralski (CZ) method, polycrystalline silicon is first melted within a crucible, such as a quartz crucible, of a crystal pulling device to form a silicon melt. The puller then lowers a seed crystal into the melt and slowly raises the seed crystal out of the melt, solidifying the melt onto the seed crystal. To produce a single high quality crystal using this method, particle density of foreign particles such as solid quartz from the continuously dissolving quartz melt support (or quartz crucible) in the liquid silicon must be very low adjacent to the solidifying crystal. Prior systems for accomplishing this goal have not been completely satisfactory. Thus, there exists a need for a more efficient and effective system and method to limit solid quartz particles immediately adjacent to the ingot.

K. Shimamura et al., Journal of Crystal Growth 142 (1994), 400-402, describe a crystal growth method using two crucibles combined with an outer and inner die.

US 8,262,797 describes a weir which is designed to define an optimal annular gap between the top of the weir and the underside of a super-adjacent heat shield in a Czochralski crystal growth system.

US 5,284,631 describes a crucible including a cylindrical partition member arranged concentrically in the crucible for use in a silicon single crystal growing apparatus

JP 04006198 A1 describes a crucible having a partition for production of a silicon single crystal.

EP 0 530 825 A1 describes a single crystal growing apparatus having a crucible assembly consisting of at least two crucibles in the form of an outer and inner crucible.

WO 91/17289 describes a silicon single crystal manufacturing apparatus which has a rotating crucible and a partition member fitted to a bottom portion of the crucible.

This Background section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

### BRIEF SUMMARY

A first aspect is a system for growing a crystal ingot from a melt. The system includes a first crucible, a second crucible, and a weir. The first crucible has a first base and a first sidewall that form a first cavity for containing the melt. The first base has a top surface. The second crucible is disposed within the first cavity of the first crucible and has a second base and a second sidewall. The second sidewall is sized for placement within the first cavity of the first crucible. The second base and the second sidewall form a second cavity. The second base has a bottom surface that is shaped to allow the second base to rest against the top surface of the first base. The second base has a thickness that is less than a thickness of the first base. The second crucible includes a crucible passageway therethrough to allow the melt in the first cavity of the first crucible to move into the second cavity of the second crucible. The weir is disposed along the second base of the second crucible at a location inward from the second sidewall to inhibit movement of the melt from a location outward of the weir to a location inward of the weir.

Said system, in one embodiment, may comprise a shield. The shield has a cylindrical leg extending downward between the second sidewall of the second crucible and the weir to form a tortuous gas and particle path between an inner area being inward of the weir and an outer area being outward of the second sidewall.

A method for growing a crystal ingot from a melt in a crystal growing system according to claim 1 is also described herein. The method includes placing feedstock material into the first cavity of the crucible, melting the feedstock material to form the melt to allow movement of the melt from the first cavity into the second cavity and then inward of the weir, and biasing oxygen upwards on the melt with quartz design so that argon at a pressure of between about 15 and about 70 Torr may be used to limit weir erosion.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated embodiments may be incorporated into any of the above-described aspects, alone or in any combination.

### BRIEF DESCRIPTION OF THE DRAWINGS

Figure 1 is a cross-sectional view of a crystal growing system in accordance with one embodiment;
Figure 2 is an enlarged cross-sectional view of a crucible assembly of Figure 1;

Corresponding reference characters indicate corresponding parts throughout the several views of the drawings.

### DETAILED DESCRIPTION

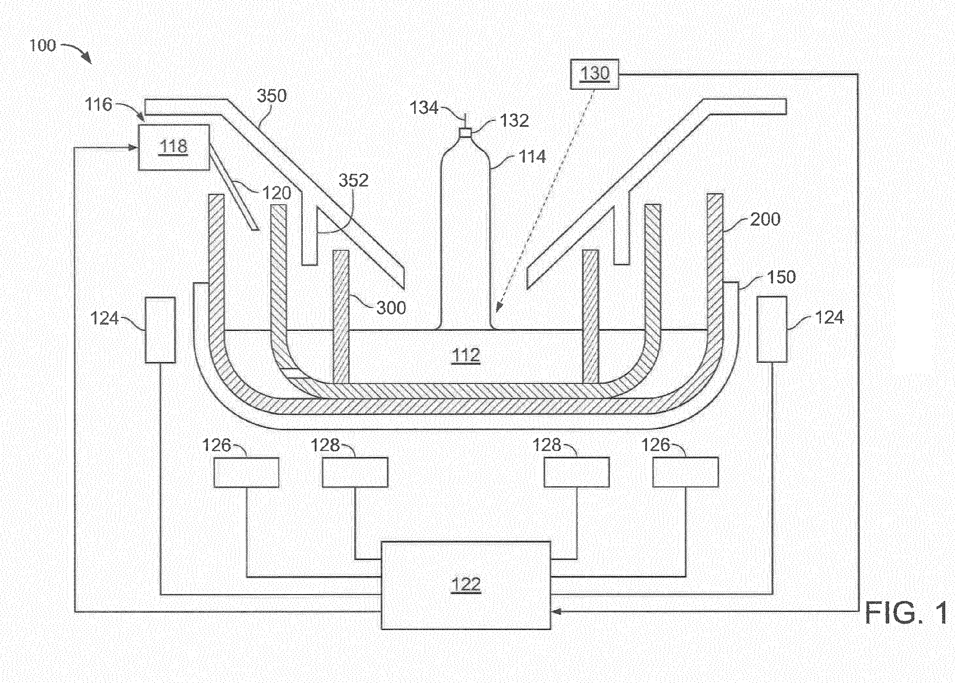

Referring to Figure 1, a crystal growing system is shown schematically and is indicated generally at 100. Note that portions of the system, particularly the furnace or puller enclosure, insulation, and susceptor support mechanisms, are omitted for clarity. The crystal growing system 100 may be used to produce a single crystal ingot by a Czochralski method.

As discussed herein, the system is described in relation to the continuous Czochralski method of producing single crystal ingots, though a batch process may be used. However, the system disclosed herein may also be used to produce multi-crystalline ingots, such as by a directional solidification process.

The crystal growing system 100 includes a crucible support or susceptor 150 supporting a crucible assembly 200 that contains silicon melt 112 from which an ingot 114 is being pulled by a puller 134 e.g., a cable. During the crystal pulling process, a seed crystal 132 is lowered by the puller 134 into the melt 112 and then slowly raised or pulled from the melt. As seed crystal 132 is slowly raised from melt 112, the single crystal ingot 114 is formed.

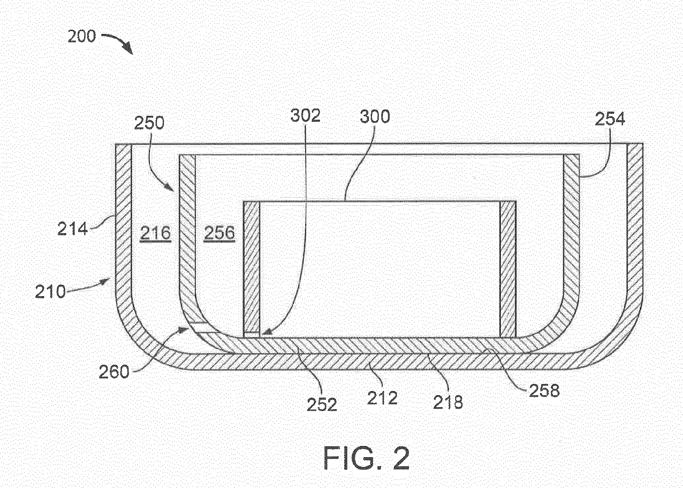

With additional reference to Figure 2, the crucible assembly 200 includes a first crucible 210 having a first base 212 and a first sidewall 214 and a second crucible 250 having a second base 252 and a second sidewall 254. The respective sidewalls of the crucibles are approximately concentric. Each sidewall 214, 254 extends around the circumference of the respective base 212, 252. The first sidewall 214 and the first base 212 form a first annular cavity 216. The second sidewall 254 and the second base 252 form a second annular cavity 256. In some embodiments, the first crucible may have an internal radius of 32-inches and the second crucible may have an internal radius of 24-inches, or these dimensions may be greater for lower oxygen or smaller for lower cost.

At least one crucible passageway 260 extends through the second crucible 250 to allow the melt to move into the second cavity 256 of the second crucible. The crucible passageway 260 may be disposed along a lower section of sidewall 254 at an elevation below the ultimate melt depth to allow consistent melt levels between the first cavity 216 and the second cavity 256. The highest rate of erosion of the crucible is at the free melt surface, where SiO can evaporate into the purge gas. In some embodiments, the second crucible side wall is of uniform thickness and the melt depth lies within the radius connecting the vertical sidewall smoothly to the base 252. In these embodiments, the crucible is radially thicker and therefore has a longer erosion life.

The second crucible 250 is sized and shaped to allow placement of the second crucible within the first cavity 216 of the first crucible 210. The first base 212 has a top surface 218 and the second base 252 has a bottom surface 258 that are complementary to allow the bottom surface 258 of the second base 252 to rest against the top surface 218 of the first base 212. In some embodiments, the bottom surface of the second base is reshaped to match the top surface of the first base, e.g., by backgrinding or water jet-cutting. In other embodiments, the bottom surface of the second base is manufactured by a crucible fusion process at a vendor with a contour matching the top surface of the first base by dimensional specification.

In some embodiments, the first crucible and the second crucible are bonded together either ex-situ before the run setup or in-situ during a run to form a single crucible assembly. The first crucible and the second crucible may be fire polished to improve bonding reliability. Fire polishing increases the OH⁻ content of the quartz, softening it at high temperature and providing a better bond. However, there is no outer bond failure consequence to melt flow control because the second crucible is a full, complete crucible. The crucible assembly of this embodiment has a single base and two concentric sidewalls extending upward therefrom.

A cylindrical melt flow barrier or weir 300 is disposed within the second cavity 256 along the second base 252 at a location inward from the second sidewall 254 to inhibit movement of the melt 112 from a location outward of the weir to a location inward of the weir. The weir 300 includes at least one weir passageway 302 extending therethrough to allow melt in the second cavity 256 to move inward of the weir.

In some embodiments, the weir is a 20-inch quartz cylinder that has a bottom edge shaped to conform to the contacting points of the interior of the 24-inch crucible and is fire polished. In these embodiments, the height of the weir provides necessary clearance to a shield 350. Using a weir that provides a large open inner melt surface area decreases the oxygen level in the ingot. An evaporative oxygen removal subsystem that uses gas flow to remove the oxygen may also be used to reduce the overall level of oxygen within the system.

In some embodiments, the weir is bonded to the second base. In these embodiments, the bonded joint remains cooler than a weir bonded directly to a single, outer crucible, since the bonded joint is not in contact with the hotter first crucible. In some embodiments, the weir passageway and the crucible passageway are unaligned to provide a labyrinth flow or tortuous path for the melt.

An outer zone is formed between the first sidewall 214 and the second sidewall 254. The use of a larger first crucible increases the volume of melt in the outer zone and allows for faster feeding of an intermediate zone, formed between the second sidewall 254 and the weir 300. The intermediate zone allows the solid feedstock material more time to melt as it transitions from the outer zone to the inner zone. The intermediate zone also allows quartz particles, which may be generated in the high temperature outer zone, time to dissolve before reaching an inner zone formed inward of the weir 300.

During the continuous Czochralski method of producing single crystal ingots, feed stock is supplied to and melted in the outer zone, while the crystal ingot is simultaneously grown in the inner zone. As a result of supplying solid feedstock material to the outer zone, some of the solid feedstock may become airborne, due to, for example dust, solid feedstock colliding with and bouncing off of other solid feedstock, or bursting of hydrogen bubbles that are formed about the solid feedstock during its melting. Pieces of the solid feedstock that become airborne are colloquially referred to as "birds." Using embodiments of this disclosure, during the crystal ingot growing process, these birds are prevented from entering the inner zone and causing a defect or dislocation in the crystal ingot.

The trajectory of every unconstrained bird cannot be determined since large silicon particles of the solid feedstock may bounce off of the melt, collide and recoil with each other, and ricochet off of the system structure. Melt flows in the inner zone can move birds in the inner melt surface toward the growing crystal ingot, causing these unmelted silicon particles to contact with, and form a defect or dislocation in the growing crystal ingot. With the large number of possible trajectories of birds or other contamination, a more practical, cost-effective shield is needed. In accordance with embodiments of this disclosure and for improved, reliable crystal growth, the trajectory of these birds is limited to the outer and intermediate zones, so that the birds are prevented from travelling into the inner zone and contacting the growing crystal ingot, especially adjacent the solid-liquid interface.

Shields of this disclosure allow no line-of-sight or direct paths from the outer zone, especially from the feedstock tube or channel, to the inner zone. By interrupting the line-of-sight between the outer zone and inner zone, the risk of particle ricochet or some Newtonian trajectory which would allow birds and contamination to enter the inner zone is reduced.

In one embodiment, the line-of-sight between the outer zone and inner zone is interrupted by overlapping cylinders between the upper melt free surface and a shield. In this embodiment, the shield does not have openings extending therethrough, which could provide a path between the outer zone and inner zone.

As noted above, the birds must be prevented from entering the inner growth zone. Referring to Fig. 1, the crystal growing system 100 of this embodiment includes shield 350 adjacent crucible assembly 200. The shield 350 has a body with a conical shape. However, any suitable horizontally rotated cross-sectional shape that separates the melt 112 from an upper portion of the system 100 and has a central opening to allow the ingot 114 to be pulled therethrough may be used. The shield 350 covers a portion of the inner and outer zones and has a cylindrical leg 352 that extends downward between the second sidewall 254 and the weir 300. The cylindrical leg 352 is disposed along the bottom of the shield 350 at a position that places the cylindrical leg between the second sidewall 254 and the weir 300 upon installation of the shield within the system 100. The cylindrical leg 352 is suitably formed as part of the shield 350, which may be made integrally or as an assembly of multiple parts. In this embodiment, both the shield 350 and the cylindrical leg 352 are made of graphite or graphite coated with silicon carbide, high purity molybdenum, though other suitable materials may be used.

The tops of the second sidewall 254 and weir 300 form a tangency cone by extending a straight line between the two tops and then rotating the line about the center of the weir 300. In other embodiments, the second sidewall 254 and weir 300 may have the same height, forming a tangency line or plane between the tops of the second sidewall 254 and the weir 300. The cylindrical leg 352 extends downward from the shield 350 through the tangency plane or cone, piercing the trapezoidal revolution volume defined by the second sidewall 254 and the weir 300, throughout the process to form a tortuous path or labyrinth arrangement to prevent birds and contamination from entering the inner zone.

As shown in Fig. 2, the second sidewall 254 and the weir 300 form gravity well between them having a highly viscous liquid melt that further reduces ricochet trajectories. In addition, birds entering the melt in the intermediate zone are liquefied and absorbed into the melt before entering the inner zone.

The spacing between the weir 300, second sidewall 254, and melt 112, and the shield 300 and cylindrical leg 350 may be sized for sufficient argon outflow through the labyrinth areas, e.g., to prevent an inward flow of gases that could carry contamination or birds, thereby to keep the very small contamination (e.g. dust or very small particles) from entering the inner zone and causing a defect or dislocation in the ingot.

The cylindrical leg 352 may be spaced from the surface of the melt a minimum distance that is determined by melt splashing between the second sidewall 254 and the weir 300. This melt splashing typically depends upon purge gas flow, pressure, and temperature, among other factors. The length of the cylindrical leg 352, or the distance that the cylindrical leg extends toward the melt and beyond the tangency cone, may also depend upon other design considerations.

In this embodiment, the second sidewall 254 and weir 300 form first and second bottom cylinders that are immersed in the melt and protrude upward therefrom. The cylindrical leg 352 forms a top cylinder extending downward from the shield 350 to overlap at least one of the first and second bottom cylinders. The cylinders are simple cylinders that form straight lines in tangential projection.

In some embodiments, one or more cylinders may form a complex cylinder that includes inward and/or outward projections or curves, as shown and discussed below with respect to Figures 3 and 4. In some embodiments, the shield has more than one downwardly extending cylindrical leg or cylinder. In other embodiments, cylindrical legs may be disposed at one or more of these locations: inward of the first bottom cylinder, between the first bottom cylinder and the second bottom cylinder, and outward of the second bottom cylinder, as shown in Figures 3 and 4 and discussed below.

Solid feedstock material 116 may be placed into the outer zone from feeder 118 through feed tube 120. The feedstock material 116 is at a much lower temperature than the surrounding melt 112 and absorbs heat from the melt as the feedstock material's temperature rises, and as the solid feedstock material liquefies in the outer zone to form an outer melt portion. As the solid feedstock material 116 (sometimes referred to as "cold feedstock") absorbs energy from melt 112, the temperature of the surrounding melt falls proportionately to the energy absorbed.

As discussed herein, the system is described in relation to the Czochralski method of producing single crystal ingots. However, the system disclosed herein may also be used to produce multi-crystalline ingots, such as by a directional solidification process.

The amount of feedstock material 116 added is controlled by feeder 118, which is responsive to activation signals from a controller 122. The amount of cooling of the melt 112 is precisely determined and controlled by controller 122. Controller 122 either adds or does not add feedstock material 116 to adjust the temperature and the mass of the melt 112. The addition of feedstock material 116 may be based on the mass of the silicon in the crucible, e.g., by measuring the weight or measuring liquid height of the melt.

As solid feedstock material 116 is added to melt 112, the surface of the melt may be disturbed. This disturbance also affects the ability of the silicon atoms of the melt 112 to properly align with the silicon atoms of the seed crystal 132. The second sidewall 254 and weir 300 inhibit inward propagation of the disturbances, as will be discussed below.

Heat is provided to crucible assembly 200 by one or more heaters 124, 126, and 128 arranged at suitable positions about the crucible assembly. Heat from heaters 124, 126, and 128 initially melt the solid feedstock material 116 and then maintains melt 112 in a liquefied state providing suitable growth conditions for the ingot 114. Heater 124 is generally cylindrical in shape and provides heat to the sides of the crucible assembly 200, and heaters 126 and 128 provide heat to the bottom of the crucible assembly. In some embodiments, heaters 126 and 128 are generally annular in shape. In other embodiments, heaters 126 and 128 are combined into a single heater.

Heaters 124, 126, and 128 are suitably resistive heaters and may be coupled to controller 122. The controller 122 controls electric current provided to the heaters, to control heater power delivery, and the feedstock material to thereby control the temperature of the melt. A sensor 130, such as a pyrometer or like temperature sensor, provides a continuous measurement of the temperature of melt 112 at the crystal/melt interface of the growing single crystal ingot 114. Sensor 130 also may be configured to measure the temperature of the growing ingot. Sensor 130 is communicatively coupled with controller 122. Additional temperature sensors may be used to measure and provide temperature feedback to the controller with respect to points that are critical to the melting of the feedstock material or in controlling the growing ingot. While a single communication lead is shown for clarity, one or more temperature sensor(s) may be linked to the controller by multiple leads or a wireless connection, such as by an infra-red data link or another suitable means.

The amount of current supplied to each of the heaters 124, 126, and 128 by controller 122 may be separately and independently chosen to optimize the thermal characteristics of melt 112. In some embodiments, one or more heaters may be disposed around the crucible to provide heat.

A second crucible having a full thickness base results in an insulating effect that requires the heaters to produce higher temperatures, which appreciably increase the operational temperature range of the first crucible. At high temperatures, quartz of the crucible breaks down and interacts with graphite from the susceptor to form gaseous carbon monoxide (CO). This gaseous carbon monoxide can cause contamination of the melt. The insulating effect is partially mitigated by the large contact area between the first and second crucible. In some embodiments, the base of the second crucible may be thinned by backgrinding or water-jet reshaping, or second crucibles may be manufactured having a thinner base, to further reduce the required operational temperatures. In some embodiments, the first crucible may be thinned along contact points with the second crucible.

As discussed above, seed crystal 132 is attached to a portion of puller 134 disposed over melt 112. The puller 134 provides movement of seed crystal 132 in a direction perpendicular to the surface of melt 112 allowing the seed crystal to be lowered down toward or into the melt, and raised up or out of the melt. To produce a high quality ingot 114, the melt 112 in an area adjacent to seed crystal 132/ingot 114 must be maintained at a substantially constant temperature and surface disruptions and foreign solid particles must be minimized.

To limit the surface disturbances and temperature fluctuations in the area immediately adjacent to seed crystal 132/ingot 114, the weir 300 is placed in the second cavity 256 of the second crucible 250. The weir 300 separates the melt 112 into the intermediate melt portion in the intermediate zone and the inner melt portion in the inner zone. The inner melt portion is inward of weir 300 and is adjacent to the seed crystal 132/ingot 114. The intermediate zone provides solid feedstock material more time to be liquefied as the feedstock material transitions from the outer zone to the inner zone. The intermediate zone also allows quartz particles, which may be generated in the high temperature outer zone, time to dissolve before reaching the inner growth zone.

The second sidewall 254 and weir 300 limit movement of melt 112 between the melt outer and inner zones. Movement of melt 112 between the zones may be permitted through passageways 260, 302 in lower sections of each of the second crucible 250 and the weir 300, respectively.

The movement of melt 112 is substantially limited to the locations of the passageways 260, 302. Placing the passageways 260, 302 along lower sections of the second sidewall 254 and weir 300 confines the movement of melt 112 to along the bottom of the crucible assembly 200. As a result, any movement of melt 112 into the inner zone is at a location beneath or directly opposite to that of the top of the melt, where ingot 114 is being pulled. This confinement of the melt movement limits surface disruptions and temperature fluctuations along the top of the inner melt portion of the melt 112, which limit dislocations in the forming ingot.

The passageways 260, 302 permit controlled movement of the melt 112 between the outer zone and the intermediate zone and the inner zone. Inhibiting or limiting the melt movement between the melt zones allows the feedstock material in the outer zone to heat to a temperature that is approximately equivalent to the temperature of the inner melt portion as the feedstock material passes into and through the intermediate zone.

The second crucible and the weir 300 are suitably made of quartz, and the melt or feedstock is silicon. The silicon melt is corrosive and could cause cut-through of the quartz of the second crucible and weir at low pressures to significantly limit the total run time of the system. To prevent excessive erosion of the second crucible and weir which would limit the total run time, oxygen is biased upwards by delivering a supply of argon at a pressure of between about 15 and about 75 Torr, or about 25 Torr or greater and a flow of between about 90 and about 140 SLPM, or less than about 100 SLPM. The higher oxygen content in the melt surface then limits the quartz erosion rate. The higher pressures reduce the velocity of the argon within the system, resulting in a decrease in silicon monoxide being evaporated from the melt surface. Less silicon monoxide is then carried into the exhaust lines preventing the premature blocking of the exhaust lines and early run termination.

The passageways may be aligned to allow controlled flow of the melt from the outer zone, through the intermediate zone, and into the inner zone. In some embodiments, the passageways through the second sidewall may be unaligned with the passageways through the weir to further restrict the flow from the outer zone, through the intermediately zone, and into the inner zone.

Referring again to Fig. 1 and Fig. 2, in a method for growing a single crystal ingot 114 in a crucible assembly 200 having a first crucible 210 and a second crucible 250, a weir 300 is placed in the second crucible. The area between the first sidewall 214 and the second sidewall 254 defines an outer zone. The area between the second sidewall 254 and the weir 300 defines an intermediate zone. The area inward of the weir 300 defines an inner zone. Feedstock material 116 is placed in the outer zone of the first cavity 216.

Heaters 124, 126 and 128 are placed adjacent to the crucible assembly 200 to provide heat for liquefying or melting the feedstock material 116, forming a melt 112. Once liquefied, the melt 112 moves from the outer zone into the intermediate zone and then into the inner zone. The movement of the melt 112 between the various zones is limited to the passageways 260, 302 through the second crucible 250 and the weir 300.

The seed crystal 132 is lowered into and then slowly raised out of the melt 112 to grow the ingot from the seed crystal. As the seed crystal 132 is slowly raised, silicon atoms from the melt 112 align with and attach to the silicon atoms of the seed crystal 132 allowing the ingot to grow larger and larger as a monocrystal. The raising of the silicon atoms from the melt 112 causes them to cool and solidify.

Inhibiting movement of the melt between the zones inhibits or prevents un-liquefied feedstock material from passing into the inner zone and causing a dislocation in the ingot. Unliquefied feedstock may disturb or negatively affect the structural integrity and the crystal structure of the ingot being formed.

In addition, the temperature of the melt increases as the melt passes from the outer zone to the intermediate zone and then into the inner zone. By the time the melt reaches the inner zone, the melt is substantially equivalent in temperature to the melt already in the inner zone. Raising the temperature of the melt before reaching the inner zone reduces the temperature fields within the inner zone. The controller may act to maintain a substantially constant temperature within the inner zone.

Further, inhibiting movement of the melt between the zones to through the passageways allows the surface of the inner zone to remain relatively undisturbed. The weir substantially prevents disturbances in the outer zone or intermediate zone from disrupting the surface of the melt in the inner zone by substantially containing the thermal and mechanical energy waves produced by the disturbances in the outer zone and intermediate zone. The disturbances are also inhibited from passing into the inner zone by the location of the passageways. The passageways are disposed below the melt top level contact and above the bottom of the second crucible and along the bottom or in a wall of the weir to allow movement of the melt into the inner zone without disrupting the surface stability of the inner zone.

In some cases, the temperature of the melt in the inner zone may suitably be measured at a location immediately adjacent the growing ingot by a sensor. In other cases, the temperature of the melt in zones other than the inner zone may suitably be measured. The sensor is connected with the controller. The controller adjusts the temperature of the melt by supplying more or less current to the heaters and by supplying more or less feedstock material to the melt. The controller is also capable of simultaneously supplying feedstock material while the seed crystal is raised from the melt and growing the ingot.

In another method for growing a single crystal ingot in a crucible assembly of any of the embodiments, the melt is separated into at least an inner zone and outer zone by at least one bottom cylinder. The solid feedstock material is supplied and liquefied into a melt in the outer zone and a crystal ingot is simultaneously grown in the inner zone. The space above the melt is separated by at least one top cylinder that extends below the top of the bottom cylinder at a location inward of bottom cylinder to interrupt a line-of-sight path between the inner zone and outer zone. The top cylinder is spaced above the melt to prevent the melt from contacting or splashing onto it. The top and bottom cylinders may be simple or complex cylinders.

The bottom cylinder and top cylinder are disposed to form a reduced opening therebetween. The reduced opening increases the argon outflow rate passing therethrough at a given argon flow, pressure, and temperature, without causing the argon outflow to be restricted or stagnated. This configuration facilitates a positive radial drift of argon outflow gas that carries dust particles (generally silicon, but sometimes other contamination) outward and away from the inner zone where the crystal ingot is being grown. Since there is a low mass density of purge gas in a rarefied furnace atmosphere of 15 to 70 Torr, such a reduced opening will affect the trajectory predominantly of very small particles.

In some embodiments, two bottom cylinders, e.g., weirs and/or crucibles, form a tangent plane or cone across their uppermost points. In these embodiments, the top cylinder, e.g. the shield, is sized and shaped to break the tangent plane or cone radially within the two bottom cylinders. In other embodiments, two top cylinders (e.g., of a shield) form a tangent plane or cone across their lowermost points. In these embodiments, the bottom cylinder, e.g., a weir is sized and shaped to break the tangent plane or cone and thereby break the line-of-sight from the outer zone to the inner zone.

The above methods may advantageously reduce oxygen in the ingot to compensate for an increase in operating pressure to extend run life, lower the consumption rate of the weir, and provide better system performance through slower quartz dissolution. A larger outer zone or feed region prevents icing in the outer feed region, allows for faster feeding and liquefying of the feedstock material in the outer zone and allows higher growth rates of the ingot. The labyrinth flow provides enough time for the solid feedstock material and generated quartz particles in the feed zone to dissolve before reaching the growing ingot. Reducing disturbances in the surface of the melt increases the yield of high zero dislocation (ZD) ingots.

Additionally, use of the above systems significantly reduces the risk associated with structural bond failure by the use of a full interior crucible instead of using a second weir. Structural bond failures of a larger weir provide solid feedstock material and quartz generated particles a direct path to the growing crystal at a random azimuthal positions, thereby degrading performance. The reductions in risk and improved efficiency not only increase the overall production of the crystal forming system, but also lowers overall operational costs.

When introducing elements of the present invention or the embodiment(s) thereof, the articles "a", "an", "the" and "said" are intended to mean that there are one or more of the elements. The terms "comprising", "including" and "having" are intended to be inclusive and mean that there may be additional elements other than the listed elements. The use of terms indicating a particular orientation (e.g., "top", "bottom", "side", etc.) is for convenience of description and does not require any particular orientation of the item described.

## Claims

1. A system for growing a crystal ingot from a melt, the system comprising:
a first crucible having a first base and a first sidewall forming a first cavity for containing the melt, the first base having a top surface;
a second crucible disposed within the first cavity of the first crucible having a second base and a second sidewall sized for placement within the first cavity of the first crucible, the second base and the second sidewall forming a second cavity, the second base having a bottom surface that is shaped to allow the second base to rest against the top surface of the first base, wherein the second base has a thickness that is less than a thickness of the first base, and the second crucible includes a crucible passageway therethrough to allow the melt in the first cavity of the first crucible to move into the second cavity of the second crucible; and
a weir disposed along the second base of the second crucible at a location inward from the second sidewall to inhibit movement of the melt from a location outward of the weir to a location inward of the weir.

2. The system of claim 1, further comprising a heater disposed for supplying heat to the first crucible and the second crucible to maintain the melt therein.

3. The system of claim 1 or 2, further comprising a feed tube disposed adjacent the first crucible for supplying a feedstock material to the first crucible at a location that is outward of the second crucible.

4. The system of any one of claims 1 to 3, wherein the second crucible is bonded to the first crucible to form an assembled crucible.

5. The system of any one of claims 1 to 4, further comprising a shield having a cylindrical leg extending downward between the second sidewall of the second crucible and the weir to form a tortuous gas and particle path.

6. The system of any one of claims 1 to 5, wherein the weir is bonded to the second base of the second crucible, the weir has a weir passageway extending therethrough to allow the melt in the second cavity of the second crucible to move through the weir.

7. The system of claim 6, wherein the weir passageway and the crucible passageway through the second crucible being unaligned to provide a tortuous path for the melt.

8. The system of any one of claims 1 to 7, further comprising a pull system for lowering and raising a seed crystal into and out of the melt.

9. The system of any one of claims 1 to 8, wherein the first base of the first crucible is thinned along contact points with the second crucible.

## Patentansprüche

1. Ein System zum Züchten eines Kristallbarrens aus einer Schmelze, wobei das System umfasst:
einen ersten Tiegel mit einer ersten Basis und einer ersten Seitenwand, die einen ersten Hohlraum zum Aufnehmen der Schmelze bilden, wobei die erste Basis eine obere Oberfläche aufweist;
einen zweiten Tiegel, der innerhalb des ersten Hohlraums des ersten Tiegels angeordnet ist, mit einer zweiten Basis und einer zweiter Seitenwand, der zum Anordnen innerhalb des ersten Hohlraums des ersten Tiegels dimensioniert ist, wobei die zweite Basis und die zweite Seitenwand einen zweiten Hohlraum bilden, wobei die zweite Basis eine untere Oberfläche aufweist, die so geformt ist, dass sie an der oberen Oberfläche der ersten Basis anliegen kann, wobei die zweite Basis eine Dicke aufweist, die geringer als eine Dicke der ersten Basis ist, und der zweite Tiegel einen Tiegeldurchgang aufweist, der sich durch diesen erstreckt, um der Schmelze in dem ersten Hohlraum des ersten Tiegels zur ermöglichen, sich in den zweiten Hohlraum des zweiten Tiegels zu bewegen; und
ein Wehr, das entlang der zweiten Basis des zweiten Tiegels an einer Position einwärts der zweiten Seitenwand angeordnet ist, um Bewegung der Schmelze von einer Stelle außerhalb des Wehrs zu einer Stelle innerhalb des Wehrs zu verhindern.

2. Das System von Anspruch 1, weiterhin umfassend eine Heizvorrichtung, die zum Zuführen von Wärme an den ersten Tiegel und den zweiten Tiegel angeordnet ist, um die Schmelze darin zu erhalten.

3. Das System von Anspruch 1 oder 2, weiterhin umfassend ein Zuführrohr, das angrenzend an den ersten Tiegel angeordnet ist, um ein Rohmaterial an den ersten Tiegel an einer Stelle außerhalb des zweiten Tiegels zu liefern.

4. Das System von irgendeinem der Ansprüche 1 bis 3, wobei der zweite Tiegel mit dem ersten Tiegel verbunden ist, um einen zusammengesetzten Tiegel zu bilden.

5. Das System von irgendeinem der Ansprüche 1 bis 4, weiterhin umfassend eine Abschirmung mit einem zylindrischen Schenkel, der sich zwischen der zweiten Seitenwand des zweiten Tiegels und dem Wehr nach unten erstreckt, um einen gewundenen Gas- und Partikelweg zu bilden.

6. Das System von irgendeinem der Ansprüche 1 bis 5, wobei das Wehr an die zweite Basis des zweiten Tiegels gebunden ist, wobei das Wehr einen Wehrdurchgang aufweist, der sich durch diesen erstreckt, um zu ermöglichen, dass sich die Schmelze in dem zweiten Hohlraum des zweiten Tiegels durch das Wehr bewegt.

7. Das System von Anspruch 6, wobei der Wehrdurchgang und der Tiegeldurchgang durch den zweiten Tiegel nicht hintereinander ausgerichtet sind, so dass ein gewundener Weg für die Schmelze gebildet wird.

8. Das System von irgendeinem der Ansprüche 1 bis 7, weiterhin umfassend ein Zugsystem zum Absenken und Anheben eines Impfkristalls in die Schmelze und aus dieser heraus.

9. Das System von irgendeinem der Ansprüche 1 bis 8, wobei die erste Basis des ersten Tiegels entlang von Kontaktpunkten mit dem zweiten Tiegel dünner ist.

## Revendications

1. Un système pour faire croître un lingot de cristal à partir d'une masse fondue, le système comprenant :
un premier creuset ayant une première base et une première paroi latérale formant une première cavité pour contenir la masse fondue, la première base ayant une surface supérieure ;
un deuxième creuset disposé dans la première cavité du premier creuset ayant une deuxième base et une deuxième paroi latérale dimensionnée pour être placée dans la première cavité du premier creuset, la deuxième base et la deuxième paroi latérale formant une deuxième cavité, la deuxième base ayant une surface de fond qui est formée pour permettre à la deuxième base de reposer contre la surface supérieure de la première base, la deuxième base ayant une épaisseur qui est inférieure à une épaisseur de la première base, et le deuxième creuset comprenant un passage de creuset au travers de lui pour permettre la masse fondue présente dans la première cavité du premier creuset de se déplacer dans la deuxième cavité du deuxième creuset ; et
un déversoir disposé le long de la deuxième base du deuxième creuset en un emplacement situé vers l'intérieur à partir de la deuxième paroi latérale pour empêcher le mouvement de la masse fondue depuis un emplacement situé à l'extérieur du déversoir vers un emplacement situé à l'intérieur du déversoir.

2. Le système selon la revendication 1, comprenant en outre un dispositif de chauffage disposé pour fournir de la chaleur au premier creuset et au deuxième creuset afin de maintenir la masse fondue dans celui-ci.

3. Le système selon la revendication 1 ou la revendication 2, comprenant en outre un tube d'alimentation disposé de façon adjacente au premier creuset pour délivrer un matériau de charge au premier creuset en un emplacement qui est situé à l'extérieur du deuxième creuset.

4. Le système selon l'une quelconque des revendications 1 à 3, dans lequel le deuxième creuset est lié au premier creuset pour former un creuset assemblé.

5. Le système selon l'une quelconque des revendications 1 à 4, comprenant en outre un bouclier ayant une branche cylindrique s'étendant vers le bas entre la deuxième paroi latérale du deuxième creuset et le déversoir afin de former un chemin de gaz et de particules tortueux.

6. Le système selon l'une quelconque des revendications 1 à 5, dans lequel le déversoir est lié à la deuxième base du deuxième creuset, le déversoir ayant un passage de déversoir s'étendant à travers lui pour permettre à la masse fondue présente dans la deuxième cavité du deuxième creuset de passer à travers le déversoir.

7. Le système selon la revendication 6, dans lequel le passage du déversoir et le passage du creuset à travers le deuxième creuset ne sont pas alignés afin de former un trajet tortueux pour la masse fondue.

8. Le système selon l'une quelconque des revendications 1 à 7, comprenant en outre un système de traction pour abaisser et élever un germe cristallin dans la masse fondue et hors de celle-ci.

9. Le système selon l'une quelconque des revendications 1 à 8, dans lequel la première base du premier creuset est amincie le long de points de contact avec le deuxième creuset.
